# EUROPÄISCHE PATENTANMELDUNG

(11) **EP 0 818 791 A1**
(43) Veröffentlichungstag der Anmeldung: **14.01.1998**
(21) Anmeldenummer: 97110465.8
(22) Anmeldetag: 26.06.1997
(51) Int. Cl.: H01F 38/42, H01F 3/14

(54) **Hochspannungstransformator**

(30) Priorität: 09.07.1996 DE 19627585
(71) Anmelder: DEUTSCHE THOMSON-BRANDT GMBH, 78048 Villingen-Schwenningen (DE)
(72) Erfinder: Goseberg, Walter, 30457 Hannover (DE)
(74) Vertreter: Wördemann, Hermes, Dipl.-Ing.

(57) **Zusammenfassung**

Ein Hochspannungstransformator, insbesondere für einen Fernsehempfänger, unterliegt einer beträchtlichen Erwärmung durch die Kupferverluste, Ein- und Ausschaltverluste der Dioden und die Kernverluste. Zur Verbesserung der Kühlung ist es bekannt, die den Transformator tragende gedruckte Leiterplatte im Bereich des Transformators mit Öffnungen zu versehen, die eine Kaminwirkung für Kühlluft bewirken.

Aufgabe ist es, die Kühlung eines derartigen Transformators weiter zu verbessern und dadurch einen verbesserten Schutz der Hochspannungsgleichrichterdioden gegen zu starke Erwärmung zu schaffen .

Das Abstandsstück (5) besteht aus einem nichtmetallischen Material, das eine gegenüber Kunststoff und Klebern deutlich erhöhte Wärmeleitfähigkeit aufweist und praktisch keine Wirbelstromverluste bewirkt. Als Material ist Keramik besonders geeignet.

Insbesondere für einen Hochspannungstransformator mit kompaktem Chassisaufbau und einer Anordnung des Luftspaltes innerhalb des Wickelkörpers

## Beschreibung

Die Erfindung geht aus von einem Hochspannungstransformator, insbesondere für einen Fernsehempfänger, gemäß dem Oberbegriff des Anspruchs 1. Ein derartiger Hochspannungstransformator unterliegt im Betrieb einer beträchtlichen Erwärmung durch unvermeidbare Verluste. Das sind insbesondere die sogenannten Kupferverluste durch die in der Primärwicklung und der Hochspannungswicklung fließenden Ströme, die Ein- und Ausschaltverluste der Hochspannungsgleichrichterdioden und die sogenannten Kernverluste durch die periodische Ummagnetisierung des Kerns aufgrund der Hysterese. Wenn die Temperatur des Transformators einen Wert von etwa 100°C überschreitet, sind insbesondere die im allgemeinen in einen Kunststoffkörper eingegossenen Hochspannungsgleichrichterdioden gefährdet. Die Erwärmung ist dann besonders groß, wenn der ganze Transformator in einem kompakten Chassis-Aufbau mit Kühlblechen in der Nähe angeordnet ist und der Luftspalt zur Verringerung der Störstrahlung innerhalb des die Wicklungen tragenden Wickelkörpers liegt.

Zur Verbesserung der Kühlung des Transformators ist es bekannt, die den Transformator tragende gedruckte Leiterplatte im Bereich des Transformators mit einer Vielzahl von Löchern zu versehen. Derartige Löcher bilden eine Kaminwirkung, indem die Luft von der dem Transformator abgewandten Seite der Leiterplatte durch die Löcher und über einen geringen Abstand zwischen der Unterkante des Transformators und der Oberseite der Leiterplatte an dem Kern und dem Wickelkörper vorbeistreicht. Mit dieser Maßnahme konnte aber nur eine Verringerung der Temperatur des Transformators von etwa 1 - 2°C erreicht werden.

Der Erfindung liegt die Aufgabe zugrunde, einen derartigen Hochspannungstransformator so weiterzubilden, daß die sich am Transformator ausbildende Temperatur verringert und ein besserer Schutz der Gleichrichterdioden gegen zu starke Erwärmung gewährleistet wird. Diese Aufgabe wird durch die im Anspruch 1 angegebene Erfindung gelöst. Vorteilhafte Weiterbildungen der Erfindung sind in den Unteransprüchen angegeben.

Die Erfindung besteht somit in der Kombination der Anordnung mit Löchern in der Leiterplatte zur Erzielung einer Kaminwirkung mit einem den Luftspalt bildenden Abstandsstück, das eine gegenüber Kunststoff und Klebern deutlich erhöhte Wärmeleitfähigkeit aufweist und praktisch keine Wirbelstromverluste bewirkt. Versuche haben folgende überraschende Wirkung gezeigt. Die Anwendung der Löcher in der Leiterplatte allein zur Bildung einer Kaminwirkung und Verbesserung der Kühlung bringt nur eine Temperaturverringerung am Trafo von etwa 1 - 2°C. Die Anwendung eines Abstandsstückes für den Luftspalt aus einem Material erhöhter Wärmeleitfähigkeit wie z.B. Keramik allein indessen bringt ebenfalls nur eine Verringerung der Temperatur um etwa 1 - 2 °C. Überraschend hat sich jedoch gezeigt, daß die Kombination dieser beiden Maßnahmen eine Temperaturverringerung um 6 - 8°C bringt. Die vorteilhafte Wirkung der Kombination der beiden Maßnahmen ist also in überraschender Weise wesentlich größer als die reine arithmetische Summe der Wirkungen der beiden Maßnahmen. Das beruht vermutlich darauf, daß die Löcher in der Leiterplatte im Sinne einer Kaminwirkung einen zur Kühlung dienenden Luftstrom am Transformator und insbesondere am unteren Kernschenkel bewirken und das Abstandsstück mit erhöhter Wärmeleitfähigkeit einen guten Wärmeaustausch im Transformator zwischen den beiden Kernteilen gewährleistet und die Wärme aus der Mitte des Transformators und vom Luftspalt nicht nur nach oben, sondern auch nach unten effektiv abgeführt wird.

Vorzugsweise liegen die der Leiterplatte zugewandten Begrenzungsflächen des Kerns einerseits und des Spulenkörpers andererseits etwa in derselben Ebene, die dann nach der Montage des Transformators auf der Leiterplatte mit einem geringen Abstand von der Oberfläche der Leiterplatte entfernt ist. Dabei ist das der Leiterplatte zugewandte, also untere Kernteil das Kernteil mit den kürzeren U-Schenkeln. Dadurch wird erreicht, daß der im allgemeinen wärmste Bereich des Transformators, nämlich der Bereich um den Luftspalt, nur einen geringen Abstand von der Leiterplatte hat und dadurch die Kühlluft, die durch die Löcher der Leiterplatte strömt, diesen wärmstem Punkt auf dem kürzesten Weg erreicht.

Das Abstandsstück hat z.B. eine gegenüber normalem Kunststoff oder Kleber um den Faktor 20 erhöhte Wärmeleitfähigkeit. Ein weiterer Vorteil besteht darin, daß ein Keramikplättchen sich mit einer Genauigkeit in der Dicke von etwa 2/100 mm herstellen läßt. Dadurch kann ein Luftspalt mit sehr genau definierter Weite erzielt werden. Da die Weite des Luftspaltes den Abgleich der Primärinduktivität des Transformators und damit die Rücklaufzeit bestimmt, kann mit einem Keramikplättchen dieser Abgleich beträchtlich vereinfacht werden.

Vorzugsweise liegt das Abstandsstück mit seinen gegenüberliegenden Oberflächen unmittelbar eng an den Stirnflächen der einander zugewandten Kernschenkel der beiden Kernteile an. Zwischen dem Abstandsstück und den Kernteilen ist dann nur noch eine sehr dünne Klebstoffschicht mit einer Dicke von einigen µm zum Zusammenhalten der Kernteile notwendig. Durch diese Maßnahme wird der angestrebte Wärmeaustausch zwischen den beiden Kernteilen gewährleistet. Vorzugsweise hat das Abstandsstück eine solche Form, daß es sich über den gesamten Kernschenkelquerschnitt erstreckt. Bei runden Kernschenkeln hat somit das Abstandsstück eine runde Form mit dem Durchmesser der Kernschenkel. Vorzugsweise hat das Abstandsstück derartige Abmessungen, daß es das ganze Volumen des Luftspaltes ausfüllt.

Das Abstandsstück kann auch unter Anordnung von Wärmeleitpaste zwischen den Kernteilen eingebracht sein, wodurch ebenfalls der Wärmeübergang zwischen den Kernteilen verbessert werden kann. Das den Luftspalt bildende Abstandsstück liegt vorzugsweise innerhalb des Spulenkörpers, um das von dem Luftspalt ausgehende Streufeld abzuschirmen.

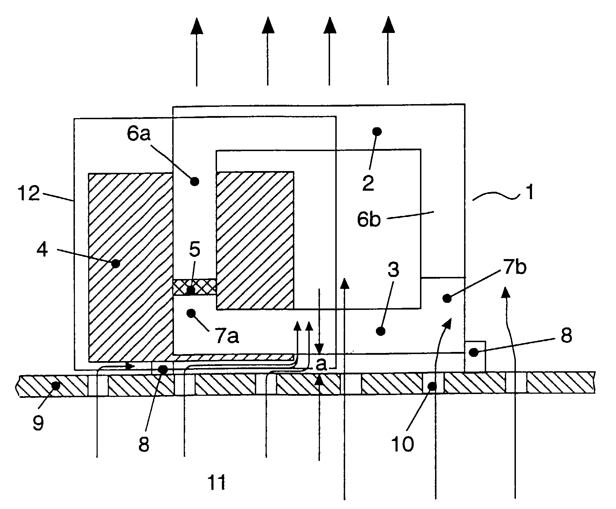

Die Erfindung wird im folgenden anhand der Zeichnung erläutert.

Die einzige Figur zeigt einen Hochspannungstransformator für einen Fernsehempfänger. Dargestellt sind der Ferritkern 1 aus zwei U-förmigen Kernteilen 2,3. Die U-Schenkel 6a und 6b des Kernteils 2 sind dabei wesentlich länger als die U-Schenkel 7a und 7b des Kernteils 3. Auf den Schenkeln 6a und 7a ist der Spulenkörper 4 angeordnet, der die Primärwicklung, die Hochspannungswicklung, die Hochspannungsgleichrichterdioden und gegebenenfalls weitere Zusatzwicklungen trägt. Zwischen den einander zugewandten Kernschenkeln 6a und 7a ist das den Luftspalt bildende Abstandsstück 5 unter Verwendung einer extrem dünnen Kleberschicht von einigen µm angeordnet. Die Dicke des Abstandsstückes 5 beträgt z.B. 2,8 mm. Die Länge des Kernschenkels 7a ist um die Dicke des Abstandsstückes 5 kürzer als die Länge des Kernschenkels 7b, so daß die beiden Kernschenkel 6b und 7b außerhalb des Spulenkörpers 4 unmittelbar zusammenstoßen. Der Transformator ist durch Abstandsstücke 8 in einem geringen Abstand a von etwa 3 - 5 mm auf der gedruckten Leiterplatte 9 montiert, wobei nicht dargestellte Anschlußpins an der Unterseite des Wickelkörpers 4 in Leiterzüge an der Unterseite der gedruckten Leiterplatte 9 eingreifen. Der Spulenkörper 4 einerseits und das Kernteil 3 andererseits enden an der der Leiterplatte 9 zugewandten Seite etwa in derselben Ebene. Das heißt, die Unterkante des Spulenkörpers 4 und die Unterkante des Kernteils 3 haben etwa denselben geringen Abstand a von der Oberseite der Leiterplatte 9. Die Leiterplatte 9 ist im Bereich des Transformators mit einer Vielzahl von Öffnungen 10 mit einem Durchmesser von etwa 2 - 3 mm versehen. Der Spulenkörper 4 ist mit einem Gehäuse 12 aus Kunststoff umgeben, das in etwa bis auf die Platine reicht. Gehäuse 12 und Spulenkörper 4 sind mit einem Kunstharz (nicht dargestellt) miteinander vergossen.

Die Wirkungsweise hinsichtlich der Kühlung ist folgende: Die Kühlluft 11, die je nach Umgebungstemperatur, Belastung des Transformators und Betriebszeit eine Temperatur von 25°C - 40°C haben kann, strömt durch die Öffnungen 10 der Leiterplatte 9 hindurch und fließt unter dem Transformator entlang. Der wärmste Bereich des Transformators liegt bekanntlich im Bereich des Luftspaltes, also des Abstandsstückes 5 innerhalb des Spulenkörpers 4. Durch die Anordnung des Kernteils 3 mit den kürzeren Kernschenkeln 7a und 7b am unteren Ende, also unmittelbar auf der Leiterplatte 9, gelangt die Kühlluft 11 auf kürzestem Wege zu diesem kritischen Bereich und bewirkt eine optimale Kühlung. Die Öffnungen 10 bilden dabei mit dem Hohlraum unter dem Transformator eine sogenannte Kaminwirkung, die einen optimalen Kühlluftstrom von der Unterseite der Leiterplatte 9 durch die Öffnungen 10 um den unteren Kernteil 3 herum bewirkt. Das Gehäuse 12 reicht vorzugsweise bis auf die Platine 9 herab, so daß die Kühlluft direkt unter den unteren Kernteil 3 entlangstreicht und nur unter diesem das Gehäuse 12 verläßt. Die den Transformator am oberen Ende verlassende Kühlluft hat eine Temperatur von ca 60 - 70°C.

Das Abstandsstück 5 ist durch ein Keramikplättchen gebildet, das mit seinen gegenüberliegenden Oberflächen unmittelbar eng an den beiden Stirnenden der einander zugewandten Kernschenkel 6a und 7a anliegt. Das Keramikplättchen 5 ist so bemessen, daß es den gesamten Querschnitt der Kernschenkel 6a und 7a ausfüllt. Bei runden Kernschenkeln 6a und 7a hat somit das Keramikplättchen 5 einen Durchmesser, der gleich dem Durchmesser der Kernschenkel 6a und 7a ist.

## Patentansprüche

1. Hochspannungstransformator, insbesondere für einen Fernsehempfänger, mit einem Spulenkörper (4) und einem Kern (1) aus zwei U-förmigen Kernteilen (2, 3), zwischen denen ein einen Luftspalt bildendes Abstandsstück (5) angeordnet ist, zur Montage auf einer Leiterplatte (9), die im Bereich des Transformators mit Öffnungen (10) zum Durchtritt von Kühlluft (11) versehen ist**, dadurch gekennzeichnet,** daß das Abstandsstück (5) aus einem nichtmetallischen Material besteht, das eine gegenüber Kunststoff und Klebern deutlich erhöhte Wärmeleitfähigkeit aufweist und praktisch keine Wirbelstromverluste bewirkt.

2. Transformator nach Anspruch 1, **dadurch gekennzeichnet,** daß die der Leiterplatte (9) zugewandten Begrenzungsflächen des Kerns (1) und des Spulenkörpers (4) etwa in derselben Ebene liegen.

3. Transformator nach Anspruch 1 oder 2, **dadurch gekennzeichnet,** daß die zwei Kernteile (2, 3) deutlich unterschiedlich lange Kernschenkel (6a, 6b; 7a, 7b) aufweisen, und daß das der Leiterplatte (9) zugewandte Kernteil (3) das Kernteil mit den kürzeren U-Schenkeln (7a, 7b) ist.

4. Transformator nach Anspruch 1 oder 3, **dadurch gekennzeichnet,** daß das Material Keramik ist.

5. Transformator nach Anspruch 4, **dadurch gekennzeichnet,** daß das Abstandsstück (5) mit gegenüberliegenden Oberflächen unmittelbar eng an den Stirnflächen der einander zugewandten Kernschenkel (6a, 7a) der beiden Kernteile (2, 3) anliegt.

6. Transformator nach Anspruch 5**, dadurch gekennzeichnet,** daß das Abstandsstück (5) eine solche Form hat, daß es sich über den gesamten Kernschenkelquerschnitt erstreckt.

7. Transformator nach Anspruch 6, **dadurch gekennzeichnet,** daß das Abstandsstück (5) derartige Abmessungen aufweist, daß es das ganze Volumen des Luftspalts ausfüllt.

8. Transformator nach Anspruch 4, **dadurch gekennzeichnet,** daß das Abstandsstück (5) unter Anwendung von Wärmeleitpaste zwischen den Kernteilen (2, 3) eingebracht ist.

9. Transformator nach Anspruch 1 oder 4, **dadurch gekennzeichnet,** daß der Luftspalt innerhalb des die Wicklungen tragenden Spulenkörpers (4) liegt.
